(19) **Europäisches Patentamt / European Patent Office / Office européen des brevets**

(11) **EP 1 508 970 B1**

(12) **EUROPEAN PATENT SPECIFICATION**

(45) Date of publication and mention
of the grant of the patent:
**01.02.2012 Bulletin 2012/05**

(51) Int Cl.:
**H04L 25/03** *(2006.01)*   **H03H 21/00** *(2006.01)*

(21) Application number: **04019609.9**

(22) Date of filing: **18.08.2004**

(54) **Multipath distortion eliminating filter**

Filter zur Beseitigung von Mehrwegverzerrungen

Filtre pour éliminer des distorsions multivoies

(84) Designated Contracting States:
**DE FR GB**

(30) Priority: **19.08.2003 JP 2003207868**

(43) Date of publication of application:
**23.02.2005 Bulletin 2005/08**

(73) Proprietor: **Pioneer Corporation
Kanagawa 212-0031 (JP)**

(72) Inventors:
• **Yamamoto, Yuji
Kawagoe-shi
Saitama-ken (JP)**
• **Kubuki, Toshiaki
Kawagoe-shi
Saitama-ken (JP)**

(74) Representative: **Popp, Eugen et al
Meissner, Bolte & Partner GbR
Widenmayerstrasse 48
80538 München (DE)**

(56) References cited:
• **VANESSA Y YANG ET AL: "A Vector Constant Modulus Algorithm for Shaped Constellation Equalization" IEEE SIGNAL PROCESSING LETTERS, IEEE SERVICE CENTER, PISCATAWAY, NJ, US, vol. 5, no. 4, 1 April 1998 (1998-04-01), pages 89-91, XP011060025 ISSN: 1070-9908**
• **JONES, D L: "A Normalized Constant-Modulus Algorithm" SIGNALS, SYSTEMS AND COMPUTERS, 1995. 1995 CONFERENCE RECORD OF THE TWENTY-NINTH ASILOMAR CONFERENCE ON, vol. 1, 30 October 1995 (1995-10-30), - 2 November 1995 (1995-11-02) pages 694-697, XP002480806 Pacific Grove, CA, USA**

**Description**

BACKGROUND OF THE INVENTION

The present invention relates to a multipath distortion eliminating filter which is mounted on an FM receiver to eliminate multipath-based distortion occurring in reception waves.

Among problems of importance in FM radio broadcasts is interference that caused by multipath-based distortion (hereinafter referred to as "multipath distortion") of the reception waves. The multipath distortion is the phenomenon that an FM reception wave signal, which should basically have a constant amplitude, varies in amplitude because of mutual interference between a plurality of incoming waves having different phases and different field intensities due to multiple wave propagation. In particular, FM receivers mounted on mobile units, such as a car radio, is sometimes subject to multipath distortion with sharp fluctuations in amplitude since the state of reception varies with movement. The multipath distortion may cause pulsed noise in FM demodulation signals, contributing to a deterioration in reproduction sound quality.

Conventionally, mobile FM receivers such as a car radio have exercised such controls as ARC (Automatic Reception Control) in order to reduce noise included in the demodulated reproduction sound. In the methods of reducing noise through ARC control and the like, however, the noise suppression has been achieved at the cost of sound quality of some sort, including the stereophonic feel of the demodulated sound. These methods have thus been far from achieving substantial elimination of the multipath distortion.

Now, with the speedup of digital signal processing technologies in recent years, attention is being given to digital FM receivers in which FM reception waves downconverted into intermediate frequency signals are converted into digital signals for digitalized signal processing at the subsequent stages, including wave detection. In such digitalized FM receivers, the multipath distortion can be eliminated through the use of adaptive digital filters that have characteristics inverse to the transfer functions of the transmission paths from broadcast stations to the receivers.

An example of such an adaptive filter is disclosed in "A Vector Constant Modulus Algorithm for Shaped Constellation Equalization" by Vanessa Yang et al, IEEE Signal Processing Letters, vol 5, no 4, April 1998.

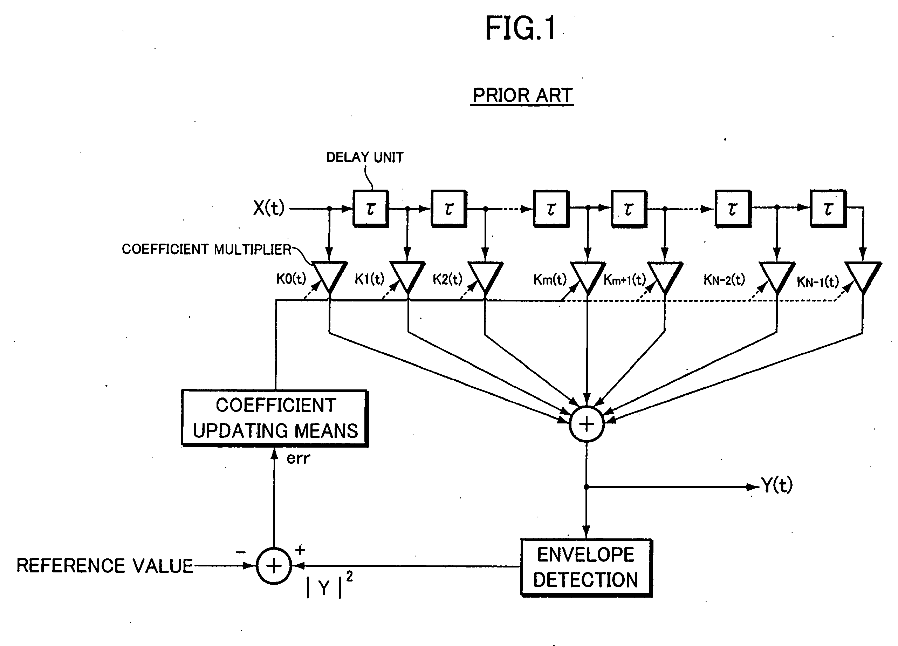

Fig. 1 shows an example of the adaptive digital filter for eliminating the multipath distortion, which is made of an FIR type filter. Tap coefficients Km of this filter are updated according to the algorithm called CMA (Constant Modulus Algorithm). More specifically, adaptive processing is exercised in consideration of the characteristic of FM signals that the amplitude should basically be constant. Here, the tap coefficients Km are updated and converged so as to minimize an error err between the envelope (amplitude) of the output signal past the filter and a reference value, whereby a filter characteristic for eliminating the multipath distortion is provided.

By the way, for the conventional adaptive filter, all the signals each coefficient multiplier outputs are added to obtain a filter output Y(t) as shown in Fig. 1, from which an amount of update of each tap coefficient Km is all determined according to the CMA method as mentioned above within an operation period thereof. However, since an operation load for updating the tap coefficient Km is heavy, an entire operation time for the adaptive filter is subject to the foregoing operation load. In other words, it was difficult for the conventional adaptive filter to improve the arithmetic processing accuracy according to the reasons of having a long critical path, being impossible to set a high reference clock in a digital operation processing, and the like.

SUMMARY OF THE INVENTION

The present invention has been achieved in view of the conventional problems described above. It is thus an object of the present invention to provide a multipath distortion eliminating filter to be mounted on an FM receiver, which can, for example, improve the operation accuracy and thereby can eliminate multipath distortion with reliability.

According to the present invention, a multipath distortion eliminating filter is provided, the multipath distortion eliminating filter comprising: a digital filter having a plurality of coefficient multipliers each having a tap coefficient, the digital filter being adapted to apply a filter operation processing to a digital reception signal containing a multipath-based distortion component to eliminate the distortion component, wherein said digital filter is further provided with a delay circuit in an output stage thereof, the output stage being adapted to provide an output signal of the digital filter; error detection means adapted to detect an error between the amplitude squared of the output signal, the output signal being delayed by an integral multiple of a unit delay time by the delay circuit provided in the output stage of the digital filter, and a reference value; and coefficient updating means adapted to compute a filter characteristic of said digital filter so as to minimize said error detected, and adapted to update each of the tap coefficients of said digital filter based on the result computed, wherein said coefficient updating means is adapted to determine an amount of correlation for each of the plurality of delayed values and said output signal, wherein the plurality of delayed values result from delaying each of the signals input to the plurality of coefficient multipliers of the digital filter by said integral multiple of a unit delay time, and wherein the coefficient updating means is further adapted to perform compression conversion processing by converting each amount of correlation into a square root of an absolute value thereof to which a sign of the amount of correlation is attached, and adapted to determine, for each tap coefficient, an amount of update by multiplying the corresponding output of the compression conversion processing with said error.

BRIEF DESCRIPTION OF THE DRAWINGS

These and other objects and advantages of the present invention will become clear from the following description with reference to the accompanying drawings, wherein:

Fig. 1 is a block diagram showing the configuration of a conventional adaptive filter;
Fig. 2 is a block diagram showing the configuration of an FM receiver according to the present invention;
Fig. 3 is a block diagram showing the configuration of an adaptive filter according to an embodiment of the present invention;
Figs. 4A and 4B are block diagrams showing configurations of the envelope detection means shown in Fig. 3;
Fig. 5 is a block diagram showing a configuration of the coefficient updating means shown in Fig. 3;
Fig. 6 is a block diagram showing another configuration of the coefficient updating means shown in Fig. 3; and
Fig. 7 is a block diagram showing still another configuration of the coefficient updating means shown in Fig. 3.

DETAILED DESCRIPTION OF THE PREFERRED EMBODIMENTS

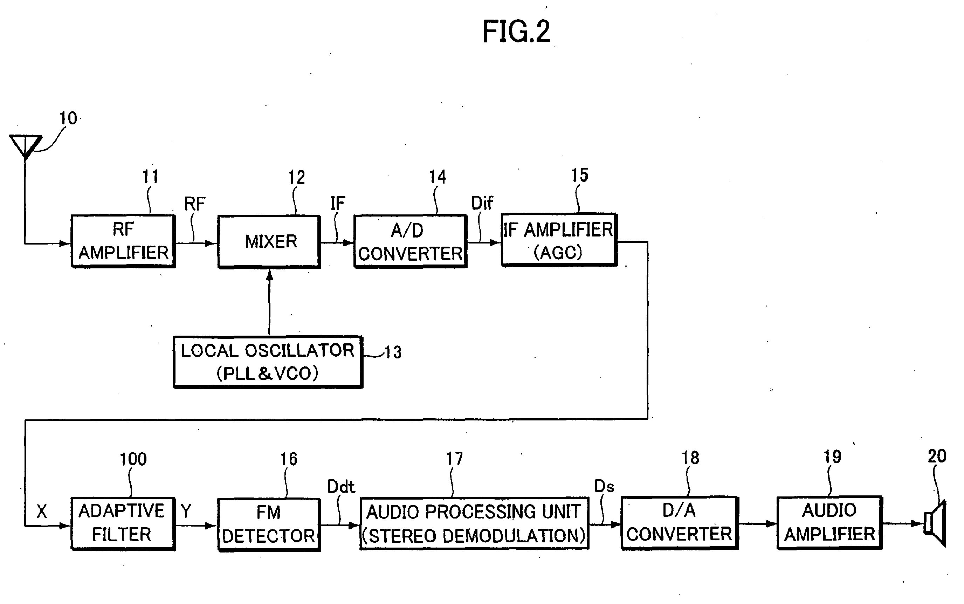

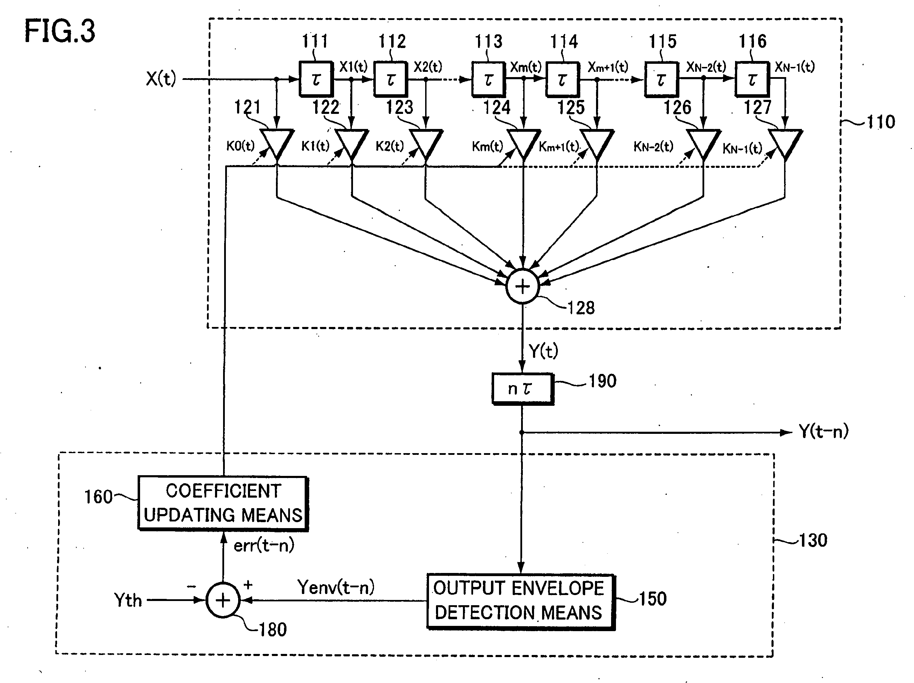

Hereinafter, a most preferred embodiment of the present invention will be described with reference to the drawings. Description will initially be given of an FM receiver on which an adaptive filter 100 according to the present embodiment is mounted. Fig. 2 is a block diagram showing the configuration of a digital FM receiver such as a car radio.
In the diagram, the FM-broadcast reception wave received by an antenna circuit 10 is amplified by an RF amplifier (radio frequency amplifier) 11. The resulting RF signal is output to a mixer 12. The mixer 12 mixes the RF signal with a local oscillation signal from a local oscillator 13, which is composed of a PLL circuit, a VCO circuit, etc. An intermediate frequency signal IF of downconverted frequency is thus generated, and supplied to an A/D converter 14. The A/D converter 14 converts the intermediate frequency signal IF, an analog signal, into a digital sample value signal (hereinafter referred to as "digital signal") Dif at predetermined regular sampling periods.
The intermediate frequency signal Dif, which is digitally converted, is amplified by an IF amplifier (intermediate frequency amplifier) 15. The IF amplifier 15 has an automatic gain control (AGC) function. It outputs the intermediate frequency signal Dif with constantly stable amplitude to the adaptive filter 100, an FM detector 16, and the like in subsequent stages regardless of the field intensity of the reception wave.
The adaptive filter 100 applies digital signal processing chiefly intended for the elimination of multipath distortion to the intermediate frequency signal Dif with adjusted amplitude, and outputs the resultant to the FM detector 16 in the subsequent stage. The configuration and operation of this adaptive filter 100 will be detailed later.
The FM detector 16 applies digital detection processing of a predetermined detection system to the intermediate frequency signal Dif past the adaptive filter 100, thereby generating a detection signal Ddt which is a composite signal. Then, in an audio processing unit 17, the detection signal Ddt is subjected to mute processing, high-cut control processing, and the like on the basis of the field intensity of the reception wave. The resultant is also demodulated in stereo, thereby being separated into right and left audio signals Ds.
Then, the audio signals Ds are converted into respective analog signals by a D/A converter 18. An audio amplifier 19 in the subsequent stage amplifies and supplies the analog audio signals to speakers 20, whereby the received FM-broadcast sound is reproduced.
Next, the adaptive filter 100 for eliminating multipath distortion occurring in the FM reception wave will be described with reference to the drawings. Fig. 3 is a block diagram showing the configuration of the adaptive filter 100. Although operations of complex values are needed originally, the shown case will deal with a simplified configuration where a unit delay time $\tau$ is 1/4 with respect to the signal period of an input signal X (t). This adaptive filter 100 comprises an FIR type digital filter 110 and adaptive processingmeans 130 . For the input signal X (t) , the digital filter 110 receives the FM intermediate frequency signal Dif that is A/D-converted. The adaptive processing means 130 performs adaptive processing on the digital filter 110 so that the digital filter 110 has a filter characteristic for functioning as a so-called inverse filter which eliminates multipath distortion occurring in the FM intermediate frequency signal.
Referring to Fig. 3, description will be given about the configuration of the digital filter 110. The digital filter 110 is made of an FIR (Finite Impulse Response) type filter of order N, including (N - 1) delay units 111-116, N coefficient multipliers 121-127, and an adder 128. Here, the order N of the digital filter 110 is determined to be an appropriate number in consideration of the frequency of the input signal, the operation accuracy of the filter, the period available for operation (critical path), etc.
When the input signal X (t) fed into the digital filter 110 is input to the delay unit 111 in the initial stage, the delay unit 111 holds a sampled value of the input signal X (t) in synchronization with a reference clock, or by the unit delay time $\tau$, and outputs it to the delay unit 112 in the subsequent stage. Similarly, the delay unit 112 delays the delayed value X1(t) of the input signal by one reference clock (unit delay time $\tau$), and outputs it to the delay unit in the subsequent stage. The subsequent delay units 113-116 also shift the delayed values of the input signal X(t) in succession while accumulating the delay times in synchronization with the reference clock.

The coefficient multipliers 121-127 multiply the input signal X(t) and the delayed values X(t-1), X(t-2), $\cdots$, X(t-N+1), which are held in the delay units 111-116 and are delayed by one, two, $\cdots$, (N-1) unit delay times, by their respective filter coefficients (hereinafter referred to as "tap coefficients"). The resultants are output to the adder 128. The adder 128 adds these coefficient-multiplied signals, and outputs the resultant as an output signal Y(t) of the digital filter 110 to a delay circuit 190 as described later.

Next, the following description will be given to the delay circuit 190 which slightly delays a timing of output of the digital filter 110, and to the adaptive processing means 130 which applies the adaptive processing to the digital filter 110.

First, the delay circuit 190 is made of a D flip-flop circuit of latency n, and holds the value of output signal Y(t) past the digital filter 110 by the delay time (n x $\tau$ time) multiplied the unit delay time $\tau$ by n. More specifically, the output signal Y (t-n) of digital filter 110 formed n x $\tau$ time ago is, in succession, supplied to the adaptive processing means 130 in synchronization with the reference clock. Here, n of the latency is a positive integer, and is adequately set at as small number as possible so as to allow the operation period of the adaptive filter 100 to have longer time, or not to cause an influence of the delay of the filter output.

Incidentally, the delayed filter output signal Y (t-n) output by the delay circuit 190 is supplied to the FM detector 16 as the output of the FM intermediate frequency signal which is subjected to a filtering processing with the adaptive filter 100.

Next, the adaptive processing means 130 would be explained. Incidentally, the adaptive processing means 130 performs processing for updating the respective tap coefficients Kmof the digital filters 110 at regular operation periods for final convergence so that the envelope Yenv(t-n) corresponding to the amplitude of the delayed output signal Y(t-n) of the digital filter 110 can have a constant amplitude.

The adaptive processing means 130 comprises envelope detection means 150 for detecting an envelope Yenv (t-n) of the delayed filter output signal Y(t-n) corresponding to the amplitude thereof, a comparator 180, and coefficient updating means 160.

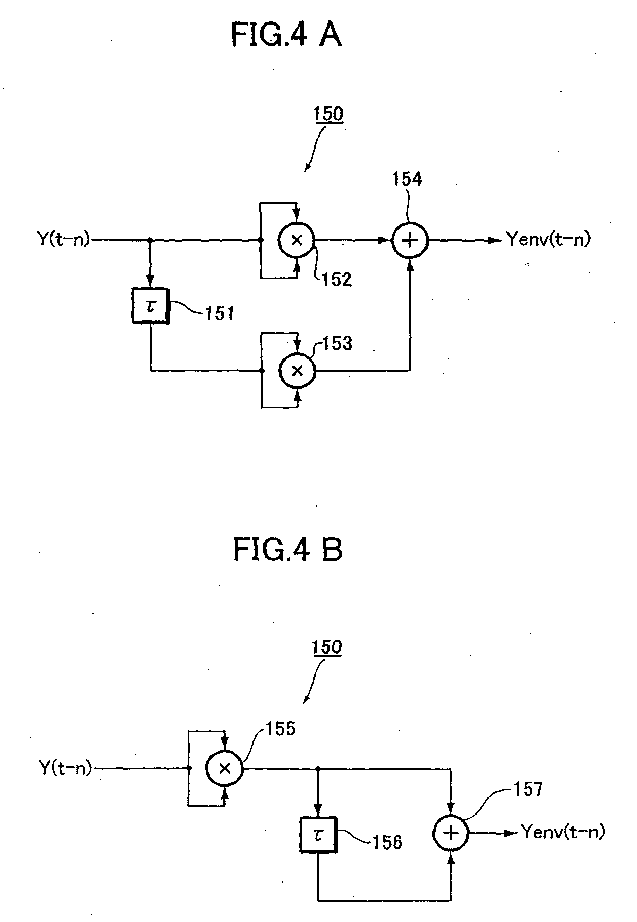

The envelope detectionmeans 150 detects the envelope Yenv (t-n) of the delayed output signal Y(t-n) based on the equation (1) as seen later. Figs. 4A and 4B are block diagrams showing examples of configuration of the envelope detection means 150.

In Fig. 4A, the envelope detection means 150 comprises a delay unit 151, multipliers 152 and 153, and an adder 154. The delay unit 151 holds the filter output signal Y (t-n) of the delay circuit 190 by the unit delay time $\tau$ in synchronization with the reference clock, and outputs the delayed value Y (t-n-1) of the delayed output signal to the multiplier 153. The multipliers 152 and 153 determine the squares of the filter output signal Y(t-n) of the delayed circuit 190 and the further delayed value Y (t-n-1), respectively. The adder 154 adds the squared values output from the multipliers 152 and 153 to determine the envelope Yenv (t-n) of the delayed filter output signal Y (t-n).

$$Yenv(t-n) = Y(t-n)^2 + Y(t-n-1)^2 \dots (1)$$

The envelope detection means 150 may have the configuration shown in Fig. 4B. In this case, the envelope detection means 150 comprises a multiplier 155, a delay unit 156, and an adder 157. The multiplier 155 determines the square of the filter output signal Y(t-n) of the delay circuit 190, and outputs it to the delay unit 156 and then the adder 157. The delay unit 156 holds the squared value of the delayed filter output signal Y(t-n) by the unit delay time $\tau$, and outputs the value delayed by the time $\tau$ to the adder 157. The adder 157 adds the squared value of the filter output signal Y (t-n) and the value delayed by the time $\tau$ to determine the envelope Yenv(t-n) of the filter output signal Y(t-n).

According to the envelope detection means 150 configured as shown in Fig. 4B, the envelope Yenv(t-n) based on the equation (1) can be determined, using the configuration with a smaller number of computing units. This causes a relative increase in operation speed.

Returning to Fig. 3, the comparator 180 subtracts a reference value Yth, which is a preset value, from the envelope Yenv(t-n) of the filter output signal, i.e., determines an error err(t-n) based on the following equation (2). The error err (t-n) is output to the coefficient updating means 160.

$$err(t-n) = Yenv(t-n) - Yth \quad \dots \quad (2)$$

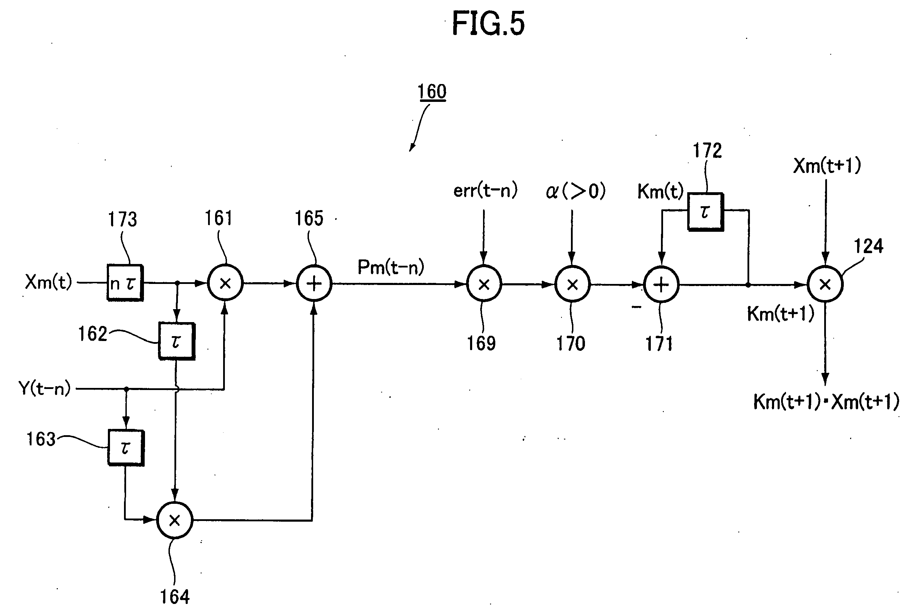

The coefficient updatingmeans 160 updates the tap coefficients Kmof the respective coefficientmultipliers 121-127 so as tominimize the error err(t-n) which is the difference between the reference value Yth and the envelope Yenv(t-n) of the delayed filter output signal. A concrete configuration of the coefficient updating means 160 is shown in Fig. 5. Fig. 5 is a block diagram of coefficient updating means 160 which updates the tap coefficient Km of the coefficient multiplier 124 in the mth stage. Similar coefficient updating means 160 are provided for the coefficient multipliers 121-127 in the zeroth, first, second, ⋯, (N-1) th stages, respectively.

Now, the coefficient updating means 160 for updating the tap coefficient Km will be described representatively with reference to Fig. 5. For input variables, the coefficient updating means 160 receives the delayed value Xm (t) of the input signal X (t), delayed by m unit delay times, along with the filter output signal Y (t-n) delayed by the delay circuit 190 and the error err(t-n) described above. The coefficient updating means 160 determines a tap coefficient Km (t+1) to be used at the next operation time, and supplies it to the coefficient multiplier 124 in the mth stage.

Specifically, the tap coefficient Km is updated based on tap coefficient updating equations given by the following equations (3-1) and (3-2):

$$Km(t+1) = Km(t) - \alpha \cdot err(t-n) \cdot Pm(t-n) \quad \dots \quad (3-1).$$

Here,

$$Pm(t-n) = Xm(t-n) \cdot Y(t-n) + Xm(t-n-1) \cdot Y(t-n-1) \quad \dots \quad (3-2),$$

$$\alpha > 0.$$

$\alpha > 0$.

In Fig. 5, a delay circuit 173 operates in synchronization with the delay circuit 190 for delaying the filter output mentioned above. More specifically, the delayed value Xm(t) input into the coefficient updating means 160 is held in the delay circuit 173 by n x τ time, and then the delayed value Xm(t-n) delayed by this time is supplied to a multiplier 161 and a delay unit 162 in the subsequent stage. Furthermore, the filter output signal Y(t-n) which has been already delayed by the delay circuit 190 is supplied to the multiplier 161 and a delay unit 163.

The multiplier 161 multiplies the delayed value Xm (t-n) of the input signal by the delayed filter output signal Y (t-n), and the resultant is output to an adder 165 in subsequent stage. A multiplier 164 multiplies the delayed value Xm (t-n-1) by the filter output signal Y(t-n-1), the respective of which is further held by the unit delay time τ by the delay units 162 and 163. The resultant is output to the adder 165.

The adder 165 adds the values output from the multipliers 161 and 164, and outputs a value Pm(t-n) which is based on the foregoing equation (3-2). Here, the value Pm(t-n) is an amount corresponding to the correlation between the delayed value Xm (t-n) of the input signal and the delayed filter output signal Y (t-n). The value Pm (t-n) will, therefore, be hereinafter referred to also as the amount of correlation.

A multiplier 169 multiplies the value Pm(t-n) as the output of the adder 165 by the error err (t-n) determined by the comparator 180 described above, and outputs the resultant to a multiplier 170 in the subsequent stage. The multiplier 170 multiplies the output value of the multiplier 169 by an attenuation coefficient α as a constant, and outputs the resultant to the negative input terminal of a subtractor 171. Incidentally, the attenuation coefficient α is a positive value which is set appropriately. The attenuation coefficient α is determined through experiments in advance in view of a balance between the time of convergence of the tap coefficient Km (t) and the stability of the coefficient update during the adaptive processing of the filter.

A delay unit 172 holds the tap coefficient Km (t) in the operation period in question (at current time) , and outputs the tap coefficient Km(t) to the positive input terminal of the subtractor 171 mentioned above. The subtractor 171 subtracts the output value of the multiplier 170 from the tap coefficient Km (t) at the present operation period, thereby determining a tap coefficient Km (t+1) for the next operation period. The subtractor 171 outputs the resultant to the coefficient multiplier 124. Consequently, the tap coefficient Km(t) of the coefficient multiplier 124 in the mth stage is updated.

Note that the coefficient multipliers 121-126 in the zeroth, first, second, ⋯, (N-1) th stages are also provided with similar coefficient updating means 160, respectively. The individual tap coefficients Km(t) are thus updated within the operation period in question. Then, the tap coefficients Km (t) are updated repeatedly so that the error err(t-n) between the envelope Yenv(t-n) of the delayed filter output signal and the reference value Yth finally becomes zero. Through the operations of converging the individual tap coefficients Km (t) , the adaptive processing of the digital filter 110 for eliminating the multipath distortion can be executed accurately.

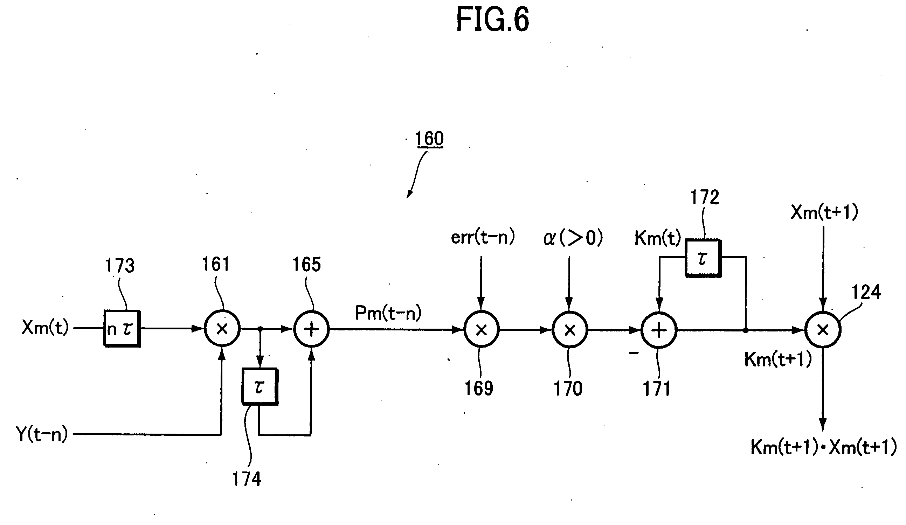

Incidentally, the value Pm(t-n) of the amount of correlation mentioned above may be computed by an arithmetic circuit having the configuration shown in Fig. 6. Fig. 6 is a block diagram showing the configuration of the coefficient updating means 160, or a diagram showing another embodiment. In the diagram, the same components as those shown in Fig. 5 are designatedby identical reference numerals or symbols.

As shown in Fig. 6, the delay circuit 173 delays the delayed time Xm (t) of input signal input into the coefficient updating means 160 by n x τ time, and then outputs the delayed value Xm (t-n) as the resultant to the multiplier 161. Furthermore, the filter output signal Y (t-n) which has been already delayed in the delay circuit 190 is supplied to the multiplier 161. The multiplier 161 multiplies these values, and outputs the resultant to the adder 165 and a delay unit 174 in the subsequent stage. The delay unit 174 holds the multipliedvalueXm(t-n) · Y (t-n) by the unit delay time τ, and outputs a delayed value Xm(t-n-1) ·Y(t-n-1) to the adder 165.

The adder 165 adds the respective outputs of the multiplier 161 and the delay unit 174 to determine the value Pm(t-n) as the amount of correlation based on the equation (3-2), and outputs the resultant to the multiplier 169.

According to the adaptive filter 100 having the coefficient updating means of the configuration shown in Fig. 6, the value Pm (t-n) as the amount of correlation based on the equation (3-2) can be determined with a smaller number of computing units. It is therefore possible to save the hardware resource and improve the operation speed.

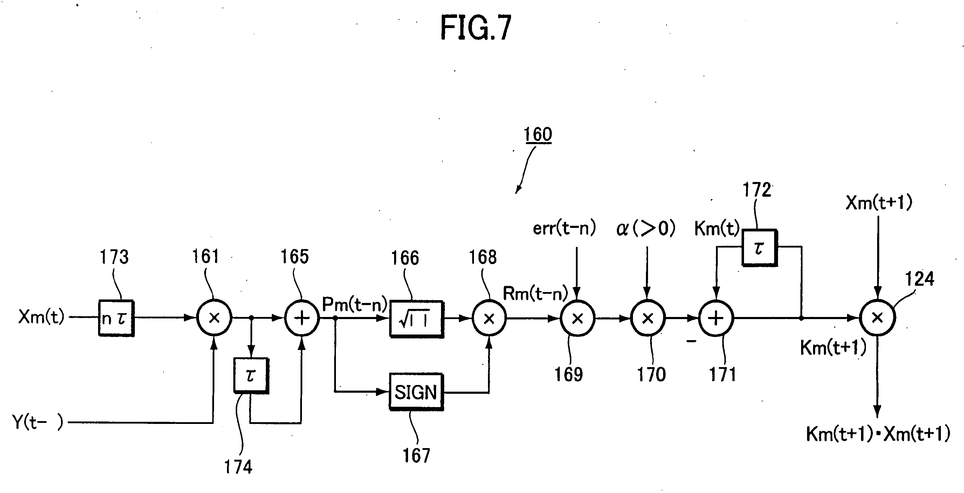

The adaptive filter 100 as another embodiment may be provided with the coefficient updating means 160 having a configuration as shown in Fig. 7, i.e., the coefficient updating means 160 may apply a compression conversion processing to the correlation-amount value Pm(t-n) to update the tap coefficient Km. Here, Fig. 7 is a block diagram showing this configuration of the coefficient updating means 160. Also, in this diagram, the same components as those shown in Fig. 6 are designated with the identical reference numerals and symbols.

Referring to Fig. 7, the value Pm (t-n) as the correlation amount output from the adder 165 is input into a square root computing unit 166 and a sign converter 167, and then is converted into a value Rm(t-n) through the compression conversion processing based on the equation (4-1). That is, the square root computing unit 166 determines a square root of the absolute value of the value Pm (t-n) , and outputs it to the multiplier 168 in the subsequent stage. Meanwhile, the sign converter 167 converts the sign of the value Pm(t-n) into 1, 0, or -1 as given by the equation (4-2), and outputs it to the multiplier 168. The multiplier 168 multiplies these values to convert the value Pm(t-n) into the value Rm(t-n) given the compression conversion processing and expressed by the equations (5-1) and (5-2), and then outputs the resultant to the multiplier 169. Then, based on the equation (6), the tap coefficient Km (t+1) used in the next operation period is determined, and then supplied to the coefficient multiplier 124 in the mth stage to update the tap coefficient Km(t).

The equations as mentioned above are as follows:

$$Rm(t-n) = SIGN\{Pm(t-n)\} \cdot \sqrt{|Pm(t-n)|} \; \dots \; (4-1),$$

where

$$SIGN(Pm) = 1 \; (Pm>0), \; 0 \; (Pm = 0), \; or \; -1 \; (Pm<0) \; \dots \; (4-2);$$

When Pm(t) ≥ 0,

$$Rm(t-n) = \sqrt{|Pm(t-n)|} \; \dots \; (5-1);$$

When Pm(t) < 0,

$$Rm(t-n) = -\sqrt{|Pm(t-n)|} \; \dots \; (5-2);$$

and

$$Km(t+1) = Km(t) - \alpha \cdot err(t-n) \cdot Rm(t-n) \quad \dots \quad (6).$$

Moreover, according to the adaptive filter 100 having the coefficient updating means 160 with the configuration as shown in Fig. 7, the value Pm(t-n) as the correlation amount between the delayed value Xm(t-n) of the input signal and the delayed filter output signal Y (t-n) is given the compression conversion processing based on the foregoing equation (4-1). As an effect thereof, such errors as numeric overflow and rounded fractions easily caused in the course of the arithmetic processing can be prevented to enable the tap coefficient Km (t) to converge faster and with more reliability.

Incidentally, the foregoing compression conversion processing for converting the value Pm (t-n) as the correlation amount into the value Rm(t-n) need not necessarily use the conversion function with a square root. For example, the same advantageous effects can also be obtained based on functions for calculating roots of higher order, such as a cube root.

According to the adaptive filter 100 having such configurations, the adaptive processing means 130 performs the adaptive processing based on two delayed values, that is, the filter output Y(t-n) as the operation output of the digital filter 110 slightly delayed by the delay circuit 190 provided in the output stage of the digital filter 110, and the delayed value Xm (t-n) of the input signal delayed in synchronization with the delay circuit 190. Thus, the operation load for calculating each tap coefficient Km(t) from the output signal Y(t) of the digital filter 110 output by the adder 128 can be reduced, so that the reference clock of the digital operation processing can be set higher. In addition, a tap order N of the digital filter 110 can be also increased. Based on these effects, the operation accuracy of the filtering processing can be improved, and also the adaptive processing of the digital filter 110 can be performed more adequately and with more reliability.

The foregoing embodiment has dealt with the case where the present invention is applied to a digital filter that is formed as an FIR type. It is understood, however, that the present invention is not limited to FIR type digital filters, but may be applied to digital filters of IIR type and the like.

**Claims**

1. A multipath distortion eliminating filter (100) comprising:

   a digital filter (110) having a plurality of coefficient multipliers (121-127) each having a tap coefficient (Km(t)), the digital filter (110) being adapted to apply a filter operation processing to a digital reception signal containing a multipath-based distortion component to eliminate the distortion component, wherein said digital filter (110) is further provided with a delay circuit (190) in an output stage thereof, the output stage being adapted to provide the output signal (Y(t-n)) of the digital filter (110),
   error detection means (150, 180) adapted to detect an error (err(t-n)) between the amplitude (Yenv(t-n)) squared of the output signal (Y(t-n)), the output signal (Y(t-n)) being delayed by an integral multiple of a unit delay time by the delay circuit (190) provided in the output stage of the digital filter (110), and a reference value (Yth); and
   coefficient updating means (160) adapted to compute a filter characteristic of said digital filter so as to minimize said error detected, and adapted to update each of the tap coefficients of said digital filter based on the result computed,
   wherein said coefficient updating means (160) is adapted to determine an amount of correlation (Pm(t-n)) for each of a plurality of delayed values and said output signal (Y(t-n)), wherein the plurality of delayed values result from delaying each of the signals input to the plurality of coefficient multipliers of the digital filter (110) by said integral multiple of a unit delay time, and
   wherein the coefficient updating means is further adapted to perform compression conversion processing by converting each amount of correlation into a square root of an absolute value thereof to which a sign of the amount of correlation is attached, and adapted to determine, for each tap coefficient, an amount of update by multiplying the corresponding output of the compression conversion processing with said error.

2. The multipath distortion eliminating filter according to claim 1, wherein said error detection means (150, 180) comprises:

   storing means (156) for holding the squared value determined by a multiplier (155) for a unit delay time;
   an adder (157) for adding the squared value and a stored value stored in said storing means; and
   a comparator (180) for comparing the added value determined by said adder, as the amplitude of said output signal, with said reference value.

3. The multipath distortion eliminating filter according to claim 1, wherein
said delay circuit is a D flip-flop circuit having a latency in which a unit delay time is multiplied by an integer.

**Patentansprüche**

1. Mehrwegverzerrungsbeseitigungsfilter (100), Folgendes umfassend:

ein digitales Filter (110) mit mehreren Koeffizientenvervielfachern (121 -127), wovon jeder einen Abgriffskoeffizienten (Km(t)) hat, wobei das digitale Filter (110) dazu ausgelegt ist, eine Filteroperationsverarbeitung an einem digitalen Empfangssignal vorzunehmen, das eine mehrwegbasierte Verzerrungskomponente enthält, um die Verzerrungskomponente zu beseitigen, wobei das digitale Filter (110) darüber hinaus in einer Ausgangsstufe mit einer Verzögerungsschaltung (190) versehen ist, wobei die Ausgangsstufe dazu ausgelegt ist, das Ausgangssignal (Y(t-n)) des digitalen Filters (110) bereitzustellen,
eine Fehlererfassungseinrichtung (150, 180), die dazu ausgelegt ist, einen Fehler (err(t-n)) zwischen der ins Quadrat erhobenen Amplitude (Yenv(t-n)) des Ausgangssignals (Y(t-n)), wobei das Ausgangssignal (Y(t-n)) durch die in der Ausgangsstufe des digitalen Filters (110) vorgesehene Verzögerungsschaltung (190) um ein ganzzahliges Vielfaches einer Einheitsverzögerungszeit verzögert wird, und einem Referenzwert (Yth) zu erfassen; und
eine Koeffizientenaktualisierungseinrichtung (160), die dazu ausgelegt ist, eine Filterkennlinie des digitalen Filters zu berechnen, um den erfassten Fehler zu minimieren, und dazu ausgelegt ist, jeden der Abgriffskoeffizienten des digitalen Filters auf Grundlage des berechneten Ergebnisses zu aktualisieren,
wobei die Koeffizientenaktualisierungseinrichtung (160) dazu ausgelegt ist, einen Korrelationsbetrag (Pm(t-n)) für jeweils mehrere Verzögerungswerte und das Ausgangssignal (Y(t-n)) zu bestimmen, wobei sich die mehreren Verzögerungswerte durch ein Verzögern der in die mehreren Koeffizientenvervielfacher des digitalen Filters (110) eingegebenen Signale um das ganzzahlige Vielfache einer Einheitsverzögerungszeit ergeben, und wobei die Koeffizientenaktualisierungseinrichtung darüber hinaus dazu ausgelegt ist, eine Komprimierungsumrechnungsverarbeitung durchzuführen, indem jeder Korrelationsbetrag in eine Quadratwurzel eines Absolutwerts von diesem umgerechnet wird, an den ein Vorzeichen des Korrelationsbetrags angehängt ist, und dazu ausgelegt ist, für jeden Abgriffskoeffizienten einen Aktualisierungsbetrag zu bestimmen, indem der entsprechende Ausgang der Komprimierungsumrechnungsverarbeitung mit dem Fehler multipliziert wird.

2. Mehrwegverzerrungsbeseitigungsfilter nach Anspruch 1, wobei die Fehlererfassungseinrichtung (150, 180) umfasst:

eine Speichereinrichtung (156) zum Speichern des durch einen Vervielfacher (155) für eine Einheitsverzögerungszeit bestimmten Quadratwerts;
einen Addierer (157) zum Addieren des Quadratwerts und eines gespeicherten Werts, die in der Speichereinrichtung gespeichert sind; und
einen Komparator (180) zum Vergleichen des durch den Addierer als Amplitude des Ausgangssignals bestimmten Additionswerts mit dem Referenzwert.

3. Mehrwegverzerrungsbeseitigungsfilter nach Anspruch 1, wobei es sich bei der Verzögerungsschaltung um eine D-Kippschaltung mit einer Latenzzeit handelt, in der eine Einheitsverzögerungszeit mit einer ganzen Zahl multipliziert wird.

**Revendications**

1. Filtre pour éliminer des distorsions multivoies (100) comprenant :

un filtre numérique (110) ayant une pluralité de multiplicateurs de coefficients (121-127) ayant chacun un coefficient de dérivation (Km(t)), le filtre numérique (110) étant apte à appliquer un traitement d'opération de filtre à un signal de réception numérique contenant une composante de distorsion multivoies pour éliminer la composante de distorsion, dans lequel ledit filtre numérique (110) est en outre pourvu d'un circuit de délai (190) dans un étage de sortie de celui-ci, l'étage de sortie étant apte à fournir le signal de sortie (Y(t-n)) du filtre numérique (110),

un moyen de détection d'erreur (150, 180) apte à détecter une erreur (err(t-n)) entre l'amplitude (Yenv(t-n)) au carré du signal de sortie (Y(t-n)), le signal de sortie (Y(t-n)) étant retardé d'un multiple intégral d'une unité de temps de délai par le circuit de délai (190) fourni dans l'étage de sortie du filtre numérique (110), et une valeur de référence (Yth) ; et

un moyen de mise à jour de coefficient (160) apte à calculer une caractéristique de filtre dudit filtre numérique afin de minimiser ladite erreur détectée, et apte à mettre à jour chacun des coefficients de dérivation dudit filtre numérique sur la base du résultat calculé,

dans lequel ledit moyen de mise à jour de coefficient (160) est apte à déterminer une quantité de corrélation (Pm(t-n)) pour chacune d'une pluralité de valeurs retardées et ledit signal de sortie (Y(t-n)), dans lequel la pluralité de valeurs retardées découlent du retard de chacun des signaux entrés dans la pluralité de multiplicateurs de coefficient du filtre numérique (110) par ledit multiple intégral d'une unité de temps de délai, et

dans lequel le moyen de mise à jour de coefficient est en outre apte à effectuer un traitement de conversion de compression en convertissant chaque quantité de corrélation en une racine carrée d'une valeur absolue de celle-ci à laquelle un signe de la quantité de corrélation est attaché, et apte à déterminer, pour chaque coefficient de dérivation, une quantité de mise à jour en multipliant la sortie correspondante du traitement de conversion de compression par ladite erreur.

2. Filtre pour éliminer des distorsions multivoies selon la revendication 1, dans lequel
ledit moyen de détection d'erreur (150, 180) comprend :

un moyen de stockage (156) pour conserver la valeur au carré déterminée par un multiplicateur (155) pour une unité de temps de délai ;

un additionneur (157) pour ajouter la valeur au carré et une valeur stockée maintenue dans ledit moyen de stockage ; et

un comparateur (180) pour comparer la valeur ajoutée déterminée par ledit additionneur, en tant qu'amplitude dudit signal de sortie, à ladite valeur de référence.

3. Filtre pour éliminer des distorsions multivoies selon la revendication 1, dans lequel
ledit circuit de délai est un circuit basculeur monostable D ayant une latence dans lequel une unité de temps de délai est multipliée par un nombre entier.

# FIG.1

## PRIOR ART

DELAY UNIT

X(t) → [τ] → [τ] → ⋯ → [τ] → [τ] → ⋯ → [τ] → [τ]

COEFFICIENT MULTIPLIER

$K_0(t)$  $K_1(t)$  $K_2(t)$  $K_m(t)$  $K_{m+1}(t)$  $K_{N-2}(t)$  $K_{N-1}(t)$

COEFFICIENT UPDATING MEANS

err

+ → Y(t)

REFERENCE VALUE — (+) ← $|Y|^2$ ← ENVELOPE DETECTION

EP 1 508 970 B1

# FIG.2

EP 1 508 970 B1

# FIG.3

# FIG.4 A

# FIG.4 B

# FIG.5

EP 1 508 970 B1

# FIG.6

EP 1 508 970 B1

# FIG.7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- A Vector Constant Modulus Algorithm for Shaped Constellation Equalization. Signal Processing Letters. IEEE, 04 April 1998, vol. 5